# EUROPEAN PATENT APPLICATION

(11) **EP 3 416 197 A1**
(43) Date of publication of application: **19.12.2018**
(21) Application number: 17750052.7
(22) Date of filing: 20.01.2017
(51) Int. Cl.: H01L 31/0232, F21S 2/00, F21S 8/10, F21S 8/12, F21V 7/22, G02B 5/20, G02B 5/26, H01S 5/06, F21W 101/10, F21Y 115/30

(54) **WAVELENGTH CONVERSION ELEMENT AND LIGHT SOURCE DEVICE**

(30) Priority: 08.02.2016 JP 2016022198
(71) Applicant: Panasonic Intellectual Property Management Co., Ltd., Osaka-shi, Osaka 540-6207 (JP)
(72) Inventor: YAMANAKA Kazuhiko, Osaka-shi, Osaka 540-6207 (JP); UENO Hirotaka, Osaka-shi, Osaka 540-6207 (JP); FUKAKUSA Masaharu, Osaka-shi, Osaka 540-6207 (JP); KOGA Toshihiro, Osaka-shi, Osaka 540-6207 (JP)
(74) Representative: Appelt, Christian W.
(86) International application number: PCT/JP2017/001900
(87) International publication number: WO 2017/138327

(57) **Abstract**

A wavelength conversion element (100) includes a substrate (5), a wavelength converting member (4) disposed on at least part of a surface of substrate (5) and having a shape of a plate or film, and a light receiver (6) integrated in the substrate (5) and including a p-n junction composed of a p-type semiconductor and an n-type semiconductor.

## Description

### TECHNICAL FIELD

The present disclosure relates to wavelength conversion elements, and light source devices including the same.

### BACKGROUND ART

Light source devices include semiconductor light-emitting devices including semiconductor light-emitting elements such as semiconductor laser elements. To emit light with highly luminous flux, in such a light source device, the wavelength conversion element is irradiated with light emitted from the semiconductor light-emitting device, and the light emitted from the wavelength conversion element is efficiently utilized.

The light source device, however, needs to prevent the light emission such that the light with highly luminous flux, as it is, is emitted from the semiconductor light-emitting element to the outside without being scattered in the wavelength conversion element. For this reason, a system which determines the state of light emission of a light source device is proposed.

A conventional light source device disclosed in PTL 1 will now be described below with reference to FIG. 21.

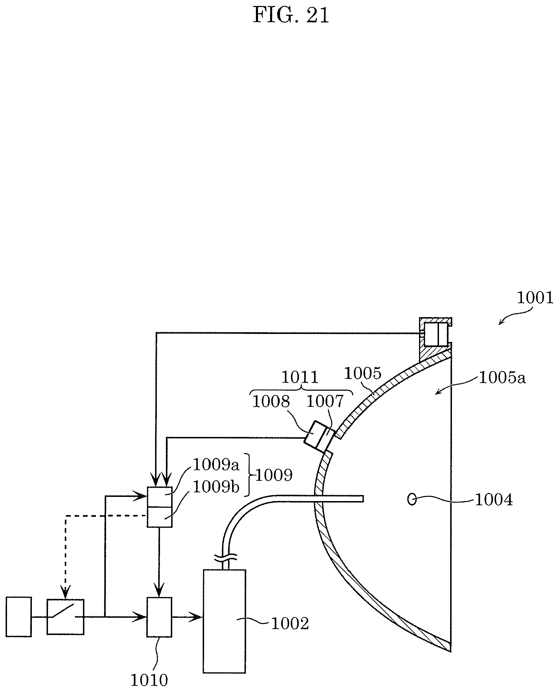

FIG. 21 is a schematic view illustrating a configuration of a conventional light source device 1001.

Conventional light source device 1001 includes semiconductor laser element 1002 which emits laser light, phosphor 1004 which converts at least part of the laser light emitted from semiconductor laser element 1002 into incoherent light, and a safety device (light detector 1011, controller 1009) which prevents coherent laser light from being emitted to the outside.

Among the light components from phosphor 1004 disposed in hollow 1005a in reflective member 1005, light receiving element 1008 in light detector 1011 receives the light components transmitted through optical filter 1007 and having a wavelength greater than about 500 nm. In the case where the laser light is emitted as it is to the outside due to damaged or chipped phosphor 1004 (abnormal light conversion), the output of light receiving element 1008 is reduced, and determining unit 1009a in controller 1009 determines that the output is below a predetermined value. In the case where driving circuit 1010 receives a signal indicating the result of the determination from control signal generator 1009b in controller 1009, driving circuit 1010 stops the driving of semiconductor laser element 1002.

### Citation List

Patent Literature PTL 1: Japanese Unexamined Patent Application Publication No. 2011-66069

### SUMMARY OF THE INVENTION

### TECHNICAL PROBLEMS

Unfortunately, because the fluorescence emitted from the wavelength converting member (phosphor) is the light emitted in random directions, it is difficult to detect a slight change in state of light emission from the wavelength converting member (phosphor).

For example, in light source device 1001 disclosed in PTL 1, phosphor 1004 is disposed away from light receiving element 1008. For this reason, while light source device 1001 can determine a failure at the final stage such as the chipping and breakage of the phosphor, light source device 1001 cannot detect a failure at the initial stag such as crack generated in part of the inside of the phosphor.

The present disclosure has been made to solve these problems. An object of the present disclosure is to provide a wavelength conversion element which can correctly determine the state of a wavelength converting member, and a light source device including the wavelength conversion element.

### SOLUTIONS TO PROBLEMS

To solve the problems described above, the wavelength conversion element according to the present disclosure includes a substrate, a wavelength converting member disposed on at least part of a surface of the substrate and having a shape of a plate or film, and a light receiver integrated in the substrate and including a p-n junction composed of a p-type semiconductor and an n-type semiconductor.

In this configuration, the light receiver including a p-n junction is integrated in the substrate on which the wavelength converting member is disposed. A light receiver having this configuration can detect the light emitted from the wavelength converting member near the wavelength converting member. Accordingly, the light receiver can correctly detect the slight change in wavelength converting member.

Moreover, in the wavelength conversion element according to the present disclosure, the light receiver may receive light which enters the substrate.

A light receiver having such a configuration can detect the light emitted from the wavelength converting member toward the substrate near the wavelength converting member. Accordingly, the light receiver can correctly detect the slight change in wavelength converting member.

Moreover, in the wavelength conversion element according to the present disclosure, a thickness of the wavelength converting member perpendicular to the surface of the substrate may be smaller than a maximum width in a direction parallel to the surface of the wavelength converting member.

In this configuration, among the light components generated in the wavelength converting member, the light receiver can detect the light components having a short propagation distance inside the wavelength converting member. Such light components have an intensity sensitive to a slight change in wavelength converting member. Accordingly, a light receiver having such a configuration can more accurately determine the state of the wavelength converting member.

The wavelength conversion element according to the present disclosure may further include an optical filter which is disposed between the wavelength converting member and the substrate and reflects the light components emitted from the wavelength converting member.

Among the light components emitted from the wavelength converting member, a wavelength converting member having such a configuration can efficiently emit the light components propagating toward the substrate to the outside of the wavelength conversion element.

Moreover, in the wavelength conversion element according to the present disclosure, the optical filter may contain one of a metal film and a multilayer dielectric film.

Such a configuration can facilitate the formation of the optical filter.

Moreover, in the wavelength conversion element according to the present disclosure, the p-type semiconductor and the n-type semiconductor may be silicon doped with impurities.

Such a configuration can facilitate the formation of the light receiver.

Moreover, in the wavelength conversion element according to the present disclosure, the light receiver may be disposed inside the substrate or between the substrate and the wavelength converting member.

Because this configuration can shorten the distance between the wavelength converting member and the light receiver, the light receiver can correctly detect a slight change in wavelength converting member.

Moreover, in the wavelength conversion element according to the present disclosure, the substrate may include a plurality of light receivers, the plurality of light receivers each being the light receiver.

Such a configuration enables correct detection of the positions of the light components which enter the wavelength converting member.

Moreover, in the wavelength conversion element according to the present disclosure, the light receiver may be disposed around the wavelength converting member in a plan view of the surface of the substrate.

Such a configuration enables correct detection of information on the light components which enter a portion around the wavelength converting member. For example, in the case where the wavelength conversion element is irradiated with light from a light-emitting device, the light from the light-emitting device, if having a deviated irradiation position, may enter the portion around the wavelength converting member rather than the wavelength converting member itself. In such a case, this configuration enables correct detection of the deviation in irradiation position of the light.

Moreover, in the wavelength conversion element according to the present disclosure, the light receiver may be disposed in a periphery of the wavelength converting member in a plan view of the surface.

Such a configuration enables detection of the position of the light from the light-emitting device to the wavelength converting member, and a reduction in region of the light receiver.

Moreover, in the wavelength conversion element according to the present disclosure, the wavelength converting member may have a plurality of regions.

Such a configuration can facilitate the formation of a wavelength converting member having a plurality of light-emitting regions.

Moreover, the light source device according to the present disclosure includes the wavelength conversion element, and a light-emitting device which emits light to be radiated to the wavelength conversion element.

In such a configuration, the light source device can achieve the same advantageous effects as those of the wavelength conversion element described above.

Moreover, in light source device according to the present disclosure, the light-emitting device may emit laser light.

Because the laser light having high directivity enters the wavelength conversion element in this configuration, the light receiver can have improved sensitivity to the slight change in the state of the wavelength converting member.

The light source device according to the present disclosure may further include an optical system which varies the light path of light emitted from the light-emitting device.

In such a configuration, the light emitted from the light-emitting device can be emitted to a desired position of the wavelength converting member. Moreover, the light having a predetermined luminous intensity distribution pattern can be emitted from the light source device by scanning the light emitted from the light-emitting device.

### ADVANTAGEOUS EFFECTS OF INVENTION

The present disclosure can provide a wavelength conversion element which can correctly determine the state of the wavelength converting member, and a light source device including the wavelength conversion element.

### BRIEF DESCRIPTION OF DRAWINGS

FIG. 1 is a schematic sectional view illustrating a configuration of a light source device according to Embodiment 1.
FIG. 2 is a schematic sectional view illustrating a configuration of a wavelength conversion element mounted on the light source device according to Embodiment 1.
FIG. 3A is a schematic sectional view for illustrating one example of the operation of the wavelength conversion element according to Embodiment 1.
FIG. 3B is a schematic sectional view for illustrating another example of the operation of the wavelength conversion element according to Embodiment 1.
FIG. 3C is a schematic sectional view for illustrating further another example of the operation of the wavelength conversion element according to Embodiment 1.
FIG. 4 is a schematic circuit block diagram of the light source device according to Embodiment 1 and a controller which operates the light source device.
FIG. 5 is a schematic sectional view illustrating a configuration of a wavelength conversion element according to Modification 1 of Embodiment 1.
FIG. 6 is a schematic sectional view illustrating a configuration of a wavelength conversion element according to Modification 2 of Embodiment 1.
FIG. 7 is a schematic sectional view illustrating a configuration of a wavelength conversion element according to Embodiment 2.
FIG. 8 is a perspective view illustrating an appearance of the wavelength conversion element according to Embodiment 2.
FIG. 9 is a schematic sectional view illustrating a configuration of a light source device according to Embodiment 2.
FIG. 10 is a schematic sectional view illustrating a configuration of a light source device according to Embodiment 3.
FIG. 11 is a schematic circuit block diagram illustrating the light source device according to Embodiment 3 and a controller for driving the light source device.
FIG. 12 is a flowchart illustrating an algorithm for control of the light source device according to Embodiment 3 and the controller.
FIG. 13 is a graph illustrating the time dependency of one example of a drive signal input to the light source device according to Embodiment 3.
FIG. 14 is a perspective view schematically illustrating a light source device according to Modification 1 of Embodiment 3.
FIG. 15 is a schematic view illustrating an example of application of the light source device according to Modification 1 of Embodiment 3.
FIG. 16 is a schematic sectional view illustrating a configuration of a wavelength conversion element according to Modification 2 of Embodiment 3.
FIG. 17 is a schematic sectional view illustrating a configuration of a wavelength conversion element according to Modification 3 of Embodiment 3.
FIG. 18 is a schematic sectional view illustrating a configuration of a light source device according to Embodiment 4.
FIG. 19 is a schematic sectional view illustrating a configuration a wavelength conversion element according to Embodiment 4.
FIG. 20 is a schematic sectional view illustrating a configuration of a wavelength conversion element according to Embodiment 5.
FIG. 21 is a schematic view illustrating a configuration of a conventional light source device.

### DESCRIPTION OF EXEMPLARY EMBODIMENTS

Embodiments according to the present disclosure will now be described below with reference to the drawings. The embodiments described below each illustrate one specific example of the present disclosure. Accordingly, numeral values, components, arrangements, positions and connection forms of the components, steps, order of the steps, and the like shown in the embodiments below are only examples, and should not be construed as limitation to the present disclosure. Among the components of the embodiments below, the components not described in an independent claim representing the most superordinate concept of the present disclosure are described as arbitrary components.

### (Embodiment 1)

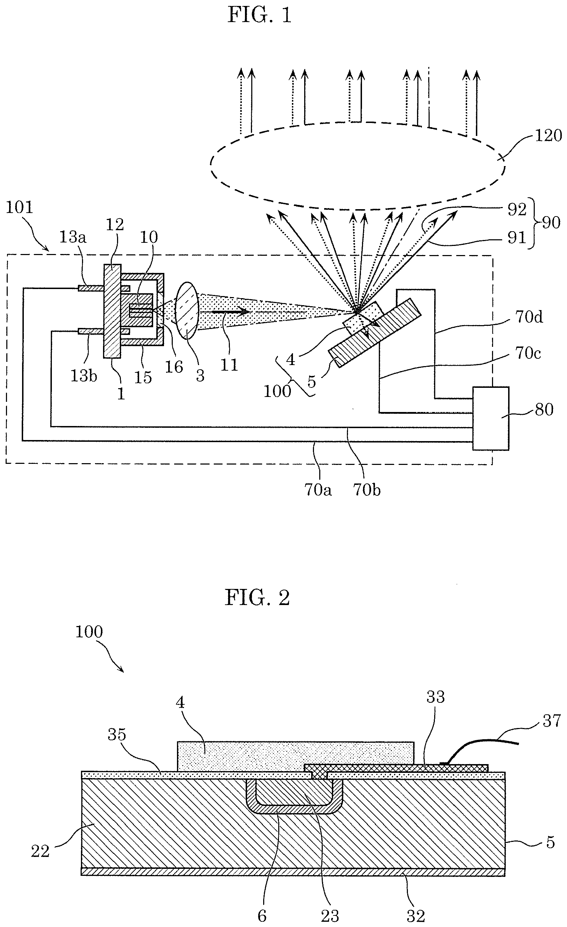

The light source device according to Embodiment 1 will now be described with reference to FIGs. 1 and 2.

FIG. 1 is a schematic sectional view illustrating a configuration of light source device 101 according to the present embodiment.

FIG. 2 is a schematic sectional view illustrating a configuration of wavelength conversion element 100 mounted on light source device 101 according to the present embodiment.

### [Basic configuration]

The basic configuration of light source device 101 and wavelength conversion element 100 according to the present embodiment will initially be described. The basic configuration described below is common to the embodiments below, and the description of the basic configuration will be omitted in the description of these embodiments below.

As illustrated in FIG. 1, light source device 101 includes wavelength conversion element 100, and light-emitting device 1 which emits light to wavelength conversion element 100. Light source device 101 further includes light converging optical system 3. Light source device 101 emits light emitted from light-emitting device 1 to wavelength converting member 4, and emits the light emitted from wavelength converting member 4 as emitted light 90 of light source device 101.

Wavelength conversion element 100 is an element which is irradiated with light components from light-emitting device 1, and converts the wavelength of at least part of the light components and emits the at least part of the light components. Wavelength conversion element 100 includes substrate 5, wavelength converting member 4, and light receiver 6.

Substrate 5 is a member on which wavelength converting member 4 is disposed, and light receiver 6 is integrated. Substrate 5 can have any shape, and may have a plate shape, for example.

Wavelength converting member 4 is a plate- or film-shaped wavelength converting member disposed on at least part of the surface of substrate 5. Wavelength converting member 4 is a member which contains at least one fluorescent material. For example, wavelength converting member 4 absorbs the light components having a wavelength of 380 nm to 490 nm, and emits fluorescence having a peak wavelength in a region of visible light at a wavelength of 420 nm to 780 nm.

For example, wavelength converting member 4 contains at least a fluorescent material which emits yellow to red light having a wavelength of 500 nm to 650 nm. Wavelength converting member 4 contains a cerium (Ce)-doped yttrium aluminum garnet fluorescent material as the fluorescent material, for example.

Light receiver 6 is integrated in substrate 5, and includes a p-n junction composed of a p-type semiconductor and an n-type semiconductor. Light receiver 6 receives light incident to substrate 5.

Light-emitting device 1 is a device which emits the light emitted to wavelength conversion element 100. Light-emitting device 1 includes semiconductor light-emitting element 10, for example. Semiconductor light-emitting element 10 is a nitride semiconductor light-emitting element including a light-emitting layer composed of a nitride semiconductor, for example. Semiconductor light-emitting element 10 is a semiconductor laser diode element including an optical waveguide, for example. Emitted light 11 emitted from semiconductor light-emitting element 10 is light having a wavelength in the region of near-ultraviolet to blue light, that is, having a peak wavelength of 380 nm to 490 nm, for example.

Emitted light 11 is laser light emitted from a semiconductor laser diode element, for example.

Light converging optical system 3 is, for example, an optical system including one or more optical elements such as a convex lens and a concave reflecting lens. Light converging optical system 3 converges at least part of components of emitted light 11 onto at least part of the surface of wavelength converting member 4.

Emitted light 90 is light emitted from wavelength converting member 4. Emitted light 90 contains the at least part of components of emitted light 11 having a wavelength converted in wavelength converting member 4. More specifically, wavelength converting member 4 irradiated with emitted light 11 emits first emitted light 91, which is scattered light components of emitted light 11, and second emitted light 92, which is other light components of emitted light 11 which are absorbed and have converted wavelengths. For example, first emitted light 91 is blue light and second emitted light 92 is yellow light. In other words, wavelength converting member 4 emits emitted light 90, which is mixed white light of first emitted light 91 and second emitted light 92.

### [Detailed configuration]

The detailed configuration of wavelength conversion element 100 and light source device 101 according to the present embodiment will now be described.

### <Wavelength conversion element>

Wavelength conversion element 100 includes substrate 5, wavelength converting member 4 disposed on at least part of a surface of substrate 5 and having a plate- or film-shape, and light receiver 6 integrated in substrate 5 and including a p-n junction composed of a p-type semiconductor and an n-type semiconductor.

For example, substrate 5 includes first semiconductor 22, which is silicon (Si) having a first conductivity, and second semiconductor 23 disposed on the side of wavelength converting member 4 of first semiconductor 22, second semiconductor 23 being silicon having a second conductivity different from the conductivity of the first conductivity. For example, the first conductivity and the second conductivity are an n-type and a p-type, respectively. Such a configuration can facilitate the manufacturing of light receiver 6. The first conductivity and the second conductivity may be a p-type and an n-type, respectively.

More specifically, first semiconductor 22 is an n-type silicon substrate having an outer shape having a length of 3 mm and a width of 3 mm and a thickness of 300 µm, for example. Second semiconductor 23 is formed through injection of a p-type dopant into the surface of first semiconductor 22.

Light receiver 6 including a p-n junction is disposed between first semiconductor 22 and second semiconductor 23. A depletion layer is disposed in light receiver 6.

The depth from the surface of light receiver 6 disposed at an interface between first semiconductor 22 and second semiconductor 23 is designed based on the entering length of the light in second semiconductor 23. For example, in the case where light receiver 6 receives light having a wavelength of 420 nm to 650 nm, light receiver 6 is disposed at a position located at a depth of 0.1 µm to 10 µm from the surface of second semiconductor 23.

Protective film 35 is disposed on the side of second semiconductor 23 of substrate 5. Protective film 35 is a silicon oxide film having a thickness of 0.1 µm to 10 µm, for example. Protective film 35 is a film for preventing the degradation of first semiconductor 22 and second semiconductor 23. Protective film 35 is not an essential component for wavelength conversion element 100. Part of the surface of protective film 35 or the entire surface thereof includes second electrode 33 composed of a metal such as nickel, aluminum, titanium, platinum, or gold, for example. An opening is disposed on part of the surface of second semiconductor 23 to electrically connect second semiconductor 23 to second electrode 33.

On the other hand, first electrode 32 composed of a metal such as nickel, aluminum, titanium, platinum, or gold, for example, is disposed on the surface of first semiconductor 22 opposite to second semiconductor 23 in substrate 5 (that is, the lower side of FIG. 2), and is electrically connected to first semiconductor 22.

Wavelength converting member 4 is a member containing one or more fluorescent materials, and is disposed on the surface of at least one of protective film 35 and second electrode 33.

More specifically, wavelength converting member 4 is formed by applying a mixed paste of Ce-doped (Gd, Y, Lu)₃(Al, Ga)₅O₁₂ fluorescent particles (average particle size D50: 5 µm) and silicone to the surface of substrate 5, and curing the paste.

For example, wavelength converting member 4 is disposed in a slightly smaller region of the main surface of substrate 5 on which wavelength converting member 4 is disposed. For example, wavelength converting member 4 has a thickness of 10 µm to 150 µm. The thickness of wavelength converting member 4 is appropriately set according to the color temperature of emitted light 90 to be emitted from the wavelength converting member and the conversion efficiency from emitted light 11 to emitted light 90, for example.

Wavelength conversion element 100 is electrically connected to an external circuit through a conductive member, such as solder or electroconductive paste, or a metal wire. In the present embodiment, second electrode 33 is connected to an external circuit through metal wire 37 as illustrated in FIG. 2.

### <Light source device>

As illustrated in FIG. 1, light source device 101 includes wavelength conversion element 100 and light-emitting device 1. Wavelength conversion element 100 and light-emitting device 1 are held by a holding member not illustrated.

In the present embodiment, light source device 101 further includes light converging optical system 3 and external connection means 80.

Light-emitting device 1 includes TO-CAN package 12, and semiconductor light-emitting element 10 packaged in package 12, for example. Package 12 includes lead pins 13a and 13b, which are wirings for applying electricity to semiconductor light-emitting element 10. Package 12 includes can 15 in which semiconductor light-emitting element 10 is encapsulated. Can 15 includes light transmissive member 16. Light transmissive member 16 is composed of glass, for example.

Light-emitting device 1 emits emitted light 11, which is blue laser light having a peak wavelength of 450 nm, for example. Emitted light 11 passes through light transmissive member 16, and is emitted to the outside of light-emitting device 1.

Lead pins 13a and 13b in light-emitting device 1 are connected to wirings 70a and 70b, respectively. Wirings 70a and 70b are, for example, flexible printed circuits including a polyimide base film and wirings formed thereon using a copper foil.

Wirings 70a and 70b are connected to external connection means 80. External connection means 80 is a connector, for example.

In light source device 101 according to the present embodiment, light converging optical system 3 is a convex lens, which converges emitted light 11 onto wavelength conversion element 100.

In the present embodiment, as illustrated in FIG. 1, light projecting member 120 is disposed on the light path of emitted light 90 emitted from wavelength conversion element 100. Light projecting member 120 is, for example, an aspherical convex lens having a large number of openings. Such an aspherical convex lens can adjust the luminous intensity distribution properties of light source device 101.

### [Operation]

### <Outline of operation>

The outline of the operation of wavelength conversion element 100 according to the present embodiment will now be described with reference to the drawings.

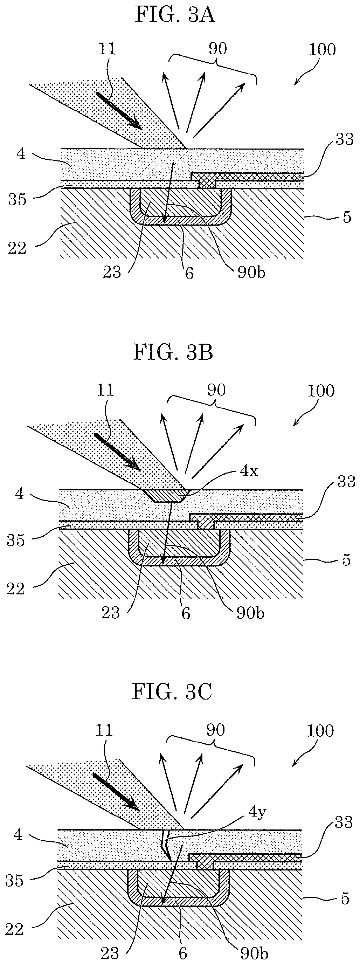

FIG. 3A is a schematic sectional view for illustrating one example of the operation of wavelength conversion element 100 according to the present embodiment.

FIG. 3B is a schematic sectional view for illustrating another example of the operation of wavelength conversion element 100 according to the present embodiment.

FIG. 3C is a schematic sectional view for illustrating further another example of the operation of wavelength conversion element 100 according to the present embodiment.

As described above, light source device 101 converges emitted light 11, which is emitted from light-emitting device 1, through light converging optical system 3, and emits the light to wavelength converting member 4 in wavelength conversion element 100. Wavelength converting member 4 irradiated with emitted light 11 emits emitted light 90 as white light.

In the present embodiment, wavelength converting member 4 disposed above light receiver 6 is irradiated with emitted light 11.

At this time, as illustrated in FIGs. 3A to 3C, light components are emitted from wavelength converting member 4 to the side of substrate 5.

Among the light components emitted to the side of substrate 5, part of components of emitted light 90b which transmit through protective film 35 or second electrode 33 enters light receiver 6 including a depletion layer in substrate 5.

The light components incident to light receiver 6 generate electron-hole pairs through photoelectric conversion. A voltage for applying reverse bias to the p-n junction is applied to first electrode 32 and second electrode 33. In the present embodiment, positive voltage and negative voltage are applied to first electrode 32 and second electrode 33, respectively. Accordingly, the electrons and holes generated in light receiver 6 travel from first electrode 32 and second electrode 33 through wirings 70c and 70d, and arrive at external connection means 80. Furthermore, the electrons and holes are transported from external connection means 80 to the outside of light source device 101.

Based on signals (i.e., photocurrent) output from light receiver 6, the state of wavelength converting member 4 can be determined. Furthermore, based on the result of detection, the operation of light-emitting device 1 can be controlled. For example, in the case where the photocurrent from light receiver 6 rapidly increases, it can be determined that wavelength converting member 4 may be broken or chipped, and the operation of light-emitting device 1 can be stopped. As described above, the present embodiment can prevent coherent emitted light 11 from being emitted as it is to the outside of light source device 101 without being scattered.

### <Circuit configuration>

Subsequently, the circuit configuration of the controller which operates light source device 101 according to the present embodiment will be described with reference to the drawings.

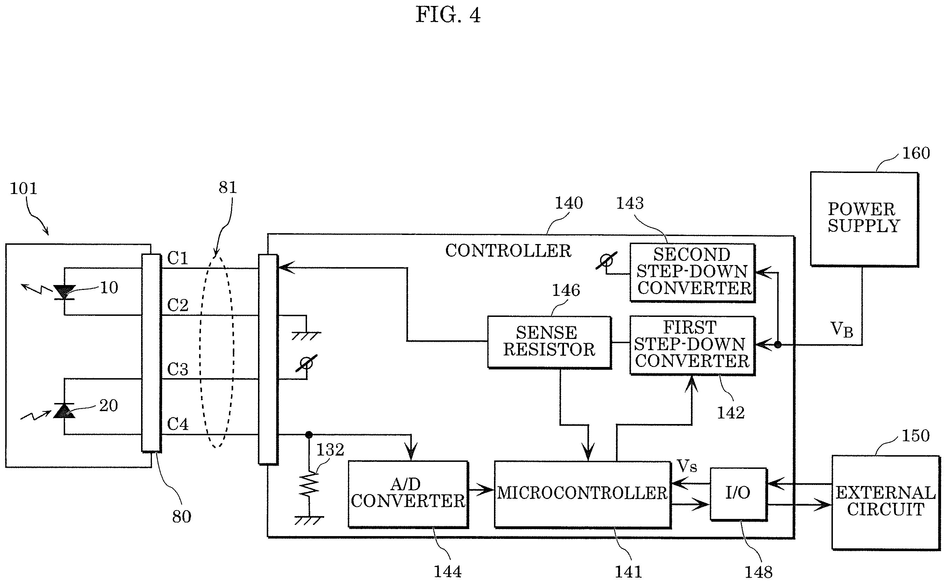

FIG. 4 is a schematic circuit block diagram of light source device 101 according to the present embodiment and controller 140 which operates light source device 101.

As illustrated in FIG. 4, light source device 101 includes semiconductor light-emitting element 10, photodetector 20, and external connection means 80.

Here, photodetector 20 is a photodiode including light receiver 6, first electrode 32, and second electrode 33.

External connection means 80 includes anode terminal C1, cathode terminal C2, first terminal C3, and second terminal C4.

An anode electrode of semiconductor light-emitting element 10 is connected to anode terminal C1 of external connection means 80, and a cathode electrode of semiconductor light-emitting element 10 is connected to cathode terminal C2 of external connection means 80. A cathode electrode of photodetector 20 is connected to first terminal C3 of external connection means 80, and an anode electrode of photodetector 20 is connected to second terminal C4 of external connection means 80.

External connection means 80 of light source device 101 is connected to controller 140 through external wiring 81.

Light source device 101 is driven by power supply 160 (such as a battery), external circuit 150 (such as a central control circuit), and controller 140. In other words, power supply 160, external circuit 150, and controller 140 form a driver of light source device 101.

Power supply 160 feeds electricity to drive controller 140.

External circuit 150 communicates with controller 140, for example. Through the communication, external circuit 150 may obtain information from controller 140, or may transmit an instruction to controller 140.

To drive semiconductor light-emitting element 10, controller 140 feeds a predetermined current Iop to semiconductor light-emitting element 10 through anode terminal C1 and cathode terminal C2.

To detect the photocurrent from photodetector 20, controller 140 receives the photocurrent through second terminal C4.

Controller 140 includes microcontroller 141, first step-down converter 142, and second step-down converter 143. Controller 140 further includes resistor element 132, A/D converter 144, I/O port 148, and sense resistor 146.

Microcontroller 141 is a circuit which controls current lop to be fed to semiconductor light-emitting element 10, based on the photocurrent from photodetector 20 and signals from external circuit 150.

First step-down converter 142 is a buck converter for feeding current lop to semiconductor light-emitting element 10.

Second step-down converter 143 is a buck converter for generating power supply voltage Vcc to be applied to photodetector 20.

Resistor element 132 is a resistor element for obtaining a voltage value corresponding to the photocurrent output from photodetector 20.

A/D converter 144 is a converter which converts the voltage value corresponding to the photocurrent from photodetector 20 into a digital signal.

I/O port 148 is a port for communicating with external circuit 150.

Sense resistor 146 is a resistor element for obtaining a voltage corresponding to current Iop to be fed from first step-down converter 142 to semiconductor light-emitting element 10.

Light source device 101 and controller 140 according to the present embodiment having the above-mentioned circuit configuration control the operation of semiconductor light-emitting element 10.

### <Details of operation>

The details of the operations of light source device 101 and controller 140 according to the present embodiment will now be described with reference to FIG. 4 and others.

As an application example of light source device 101 according to the present embodiment, an example will be described in which light source device 101 is used as a headlamp for vehicles such as cars. Initially, the operation of light source device 101 is prepared by starting the engine of a vehicle, for example. By the starting of the engine, power supply 160 feeds electricity (voltage V_{B}) to controller 140, and second step-down converter 143 generates power supply voltage Vcc.

External circuit 150 then transmits predetermined instruction signals to microcontroller 141 through I/O port 148, and current lop flows from first step-down converter 142 through external wiring 81 to anode terminal C1 of external connection means 80.

Current lop fed to anode terminal C1 is fed from external wiring 81 to external connection means 80. As illustrated in FIG. 1, current lop is then fed through wirings 70a and 70b to lead pins 13a and 13b, and is fed to semiconductor light-emitting element 10 through a metal wire not illustrated. Thereby, semiconductor light-emitting element 10 emits emitted light 11.

Emitted light 11 emitted from semiconductor light-emitting element 10 in light-emitting device 1 enters wavelength converting member 4 in wavelength conversion element 100 through light converging optical system 3.

Wavelength converting member 4 scatters part of components of emitted light 11, and emits first emitted light 91. Wavelength converting member 4 also absorbs part of components of emitted light 11, and emits second emitted light 92.

Emitted light 90 is mixed light of first emitted light 91 and second emitted light 92. For example, in the case where first emitted light 91 is blue light and second emitted light 92 is yellow light, light source device 101 emits white emitted light 90.

At this time, as illustrated in FIG. 3A, part of emitted light 90b enters light receiver 6. The light received in light receiver 6 is converted into a photocurrent through photoelectric conversion, and is input into controller 140. The photocurrent input into controller 140 is converted into a voltage signal by resistor element 132, and is input into microcontroller 141.

### <Failure mode>

The operation of light source device 101 in a failure mode will now be described in which light source device 101 according to the present embodiment does not output normal emitted light 90.

Because emitted light 11 is converged onto wavelength converting member 4, the light intensity on wavelength converting member 4 becomes locally high. For this reason, the temperature of wavelength converting member 4 may locally and rapidly increase. Such an increase in temperature causes the case where material degeneration 4x is locally generated as illustrated in FIG. 3B, and the case where local crack 4y is generated as illustrated in FIG. 3C, for example.

In light source device 101 according to the present embodiment, the operation to detect material degeneration 4x illustrated in FIG. 3B will be first described.

As described above, wavelength converting member 4 has a thickness of about 10 µm to 150 µm, for example. Protective film 35 has a thickness of about 0.1 µm to 10 µm, for example.

Light receiver 6 is disposed at a predetermined position having a depth of 0.1 µm to 10 µm from the surface of substrate 5, for example.

It is presumed that material degeneration 4x is generated in a portion of the surface of wavelength converting member 4 which receives light having high intensity and thus has a locally increased temperature. For this reason, by disposing light receiver 6 at a position (both?) out of the light path of emitted light 90 and close to material degeneration 4x, a slight change in wavelength converting member 4 can be correctly detected as a change in emitted light 90b. Because light receiver 6 is disposed out of the light path of emitted light 90, light receiver 6 does not obstruct the propagation of emitted light 90.

In the present embodiment, for example, light receiver 6 may be disposed at a position of 170 µm or deeper from the surface of wavelength converting member 4.

Similarly, also in the case illustrated in FIG. 3C where the generation of crack 4y is detected, light receiver 6 disposed at a position close to crack 4y can correctly detect a slight change in wavelength converting member 4 as a change in emitted light 90b.

In the configuration described above, the quantity of emitted light 90b is output from light source device 101 as a photocurrent, is converted into a signal in resistor element 132 and A/D converter 144, and is input into microcontroller 141.

Microcontroller 141 determines this signal. When microcontroller 141 determines that wavelength converting member 4 has failure, microcontroller 141 controls first step-down converter 142 to turn current Iop to 0, stopping the operation of semiconductor light-emitting element 10.

### [Advantageous effects]

As described above, in wavelength conversion element 100 according to the present embodiment, light receiver 6 including a p-n junction is integrated in substrate 5 on which wavelength converting member 4 is disposed. Such a configuration enables light receiver 6 to detect light emitted from wavelength converting member 4 near wavelength converting member 4. Accordingly, light receiver 6 can correctly detect a slight change in wavelength converting member 4.

In the present embodiment, light receiver 6 can also detect light emitted from wavelength converting member 4 toward substrate 5 near wavelength converting member 4. Accordingly, light receiver 6 can correctly detect a slight change in wavelength converting member 4.

In the present embodiment, the thickness of wavelength converting member 4 in the direction perpendicular to the main surface of substrate 5 is smaller than the maximum width of wavelength converting member 4 in the direction parallel to the main surface of substrate 5. For this reason, among the light components generated in wavelength converting member 4, light receiver 6 can detect the light components having a short propagation distance inside wavelength converting member 4. Such light components have an intensity sensitive to a slight change in wavelength converting member 4. Accordingly, light receiver 6 can more correctly determine the state of wavelength converting member 4.

Moreover, light receiver 6 is disposed within substrate 5 in the present embodiment, enabling a reduction in distance between wavelength converting member 4 and light receiver 6. For this reason, light receiver 6 can correctly detect a slight change in wavelength converting member 4.

Moreover, light source device 101 according to the present embodiment includes wavelength conversion element 100, and a light-emitting device which emits light to be radiated to wavelength conversion element 100. Such a configuration can achieve light source device 101 having the same advantageous effects as those of wavelength conversion element 100.

In light source device 101 according to the present embodiment, light-emitting device 1 emits laser light. Because laser light having high directivity enters wavelength conversion element 100 in such a configuration, light receiver 6 can have improved sensitivity to a slight change in the state of wavelength converting member 4.

### (Modification 1 of Embodiment 1)

Wavelength conversion element according to Modification 1 of Embodiment 1 will now be described. Unlike wavelength conversion element 100 according to Embodiment 1, the wavelength conversion element according to the present modification includes an optical filter between wavelength converting member 4 and substrate 5. Differences between the wavelength conversion element according to the present modification and wavelength conversion element 100 according to Embodiment 1 will be mainly described below with reference to the drawings.

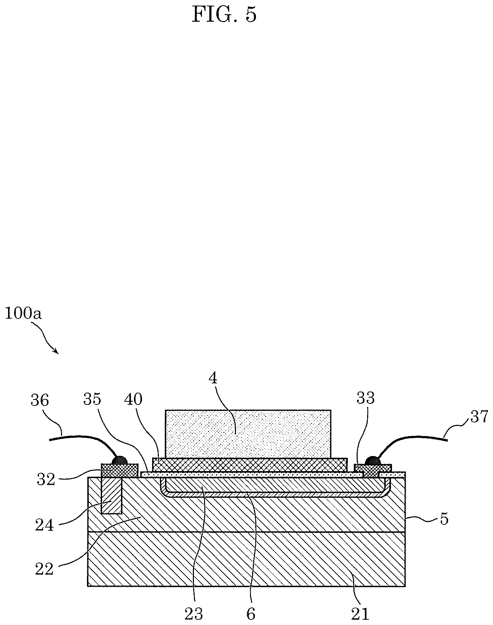

FIG. 5 is a schematic sectional view illustrating a configuration of wavelength conversion element 100a according to the present modification.

As illustrated in FIG. 5, wavelength conversion element 100a according to the present modification includes an optical filter which is disposed between wavelength converting member 4 and substrate 5 and reflects light emitted from wavelength converting member 4.

Optical filter 40 is a metal film made of silver alloy, a multilayer dielectric film, or a film in combination thereof, for example. Such a configuration can facilitate the formation of optical filter 40 between wavelength converting member 4 and substrate 5 while allowing free design of the reflectance of optical filter 40.

Optical filter 40 reflects at least one of the light components having a wavelength of emitted light 11 and light components having a converted wavelength (fluorescence) emitted from light wavelength converting member 4. Thereby, among the light components emitted from wavelength converting member 4, the light components propagating toward substrate 5 can be efficiently emitted to the outside of wavelength conversion element 100a, minimizing the light components which enter from wavelength converting member 4 to light receiver 6.

For example, optical filter 40 is designed so as to reflect 95% of at least one of the light components having a wavelength of emitted light 11 and the light components emitted from wavelength converting member 4 and having a converted wavelength. At this time, only 5% of the light components from wavelength converting member 4 toward light receiver 6 can transmit through optical filter 40, and can be input to light receiver 6. At this time, by adjusting the thickness of first semiconductor 22 and second semiconductor 23 forming the light receiver and the amount of a dopant, light receiver 6 having sufficient sensitivity even to a small quantity of light can be disposed. The reflectance of optical filter 40 described above is one example, and the optical filter is preferably designed so as to reflect light at a high reflectance, for example, in any proportion of 80% to 99.9%. Such a configuration can increase the luminous flux of the light emitted from wavelength conversion element 100a, and can cause predetermined emitted light to enter light receiver 6 and can detect a slight change in the state of wavelength converting member 4.

In substrate 5 in the present modification, for example, an n-type dopant is injected into a p-type silicon substrate, i.e., substrate 21 to form an n-type silicon region, i.e., first semiconductor 22. An n-type dopant having a high concentration is then injected to form an n+ region, i.e., third semiconductor 24, and a p-type dopant is injected to form a p-type layer, i.e., second semiconductor 23. First electrode 32 is electrically connected to third semiconductor 24. Protective film 35 is disposed on the surface of second semiconductor 23. Second semiconductor 23 is electrically connected to second electrode 33.

Substrate 5 is wired to the outside through metal wires 36 and 37 from first electrode 32 and second electrode 33 disposed on the main surface on which wavelength converting member 4 is disposed.

Such a configuration enables the formation of wiring only on one main surface of substrate 5, facilitating wiring by wire bonding, for example.

In the configuration described above, optical filter 40 may be formed by applying a mixture of white nanoparticles (such as TiO₂ nanoparticles having a particle size of 1 µm or less) and a transparent binder (such as silicone), and curing the applied mixture.

### (Modification 2 of Embodiment 1)

The wavelength conversion element according to Modification 2 of Embodiment 1 will now be described. Unlike wavelength conversion element 100 according to Embodiment 1, the wavelength conversion element according to the present modification is packaged. Differences between the wavelength conversion element according to the present modification and wavelength conversion element 100 according to Embodiment 1 will be mainly described below with reference to the drawings.

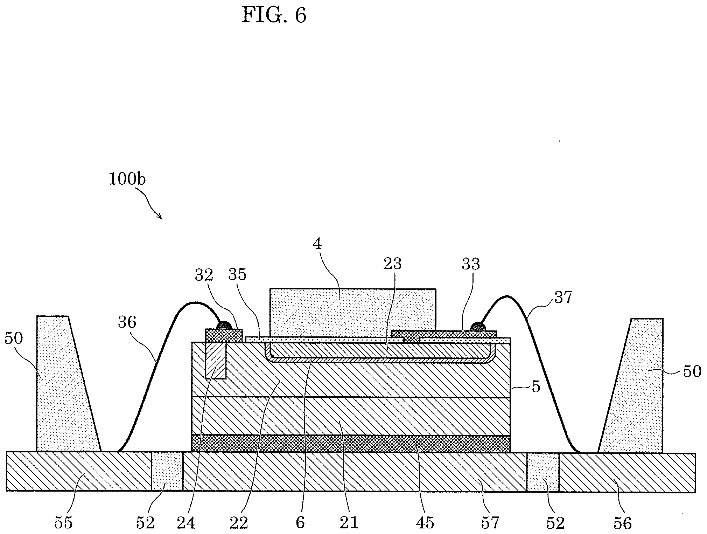

FIG. 6 is a schematic sectional view illustrating a configuration of wavelength conversion element 100b according to the present modification,

As illustrated in FIG. 6, in wavelength conversion element 100b according to the present modification, substrate 5 is fixed to package 50 through adhesive layer 45.

In package 50, first terminal 55, second terminal 56, and third terminal 57 are buried into insulating material 52.

Insulating material 52 is made of a plastic, for example. First terminal 55, second terminal 56, and third terminal 57 are terminals having copper-plated surfaces, for example.

First terminal 55 and second terminal 56 are used for wiring to the outside of the package.

First electrode 32 disposed on substrate 5 is connected to first terminal 55 through metal wire 36. Second electrode 33 disposed on substrate 5 is connected to second terminal 56 through metal wire 37.

Wavelength conversion element 100 according to the present modification having such a configuration can facilitate the handling of light source device 101 during manufacturing thereof, for example.

### (Embodiment 2)

The wavelength conversion element and light source device according to Embodiment 2 will now be described. Unlike wavelength conversion element 100 according to Embodiment 1, the wavelength conversion element according to the present embodiment includes a plurality of light receivers. Differences between the wavelength conversion element and the light source device according to the present embodiment and wavelength conversion element 100 and light source device 101 according to Embodiment 1 will be mainly described below.

### [Wavelength conversion element]

The wavelength conversion element according to the present embodiment will be first described with reference to the drawings.

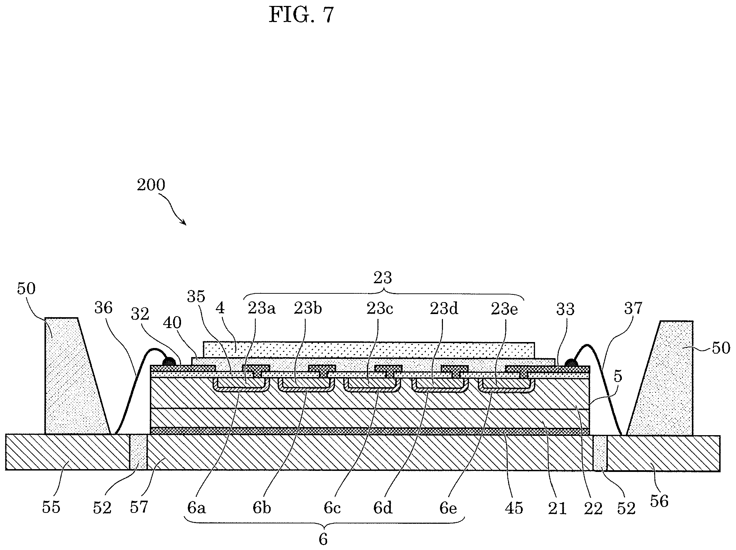

FIG. 7 is a schematic sectional view illustrating a configuration of wavelength conversion element 200 according to the present embodiment.

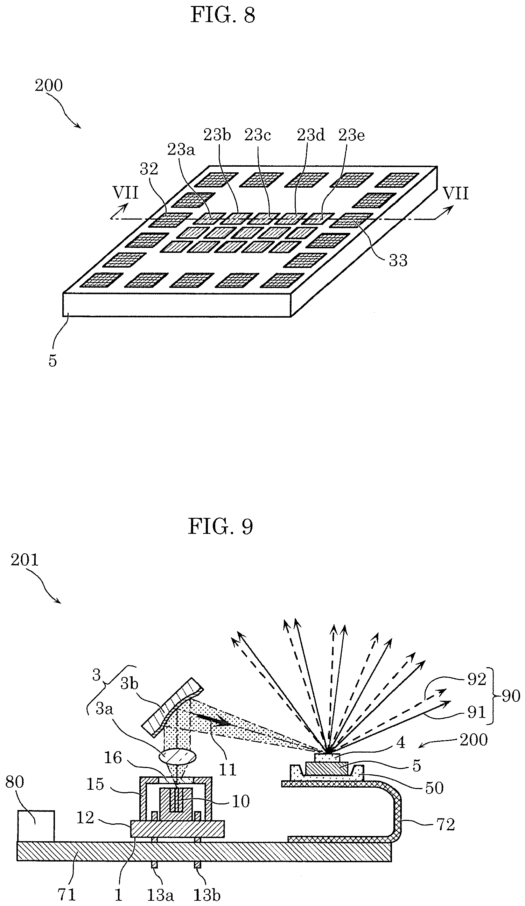

FIG. 8 is a perspective view illustrating an appearance of wavelength conversion element 200 according to the present embodiment. FIG. 8 illustrates a schematic view of the appearance of wavelength conversion element 200 where wavelength converting member 4 and others are not disposed yet. FIG. 7 is a sectional view corresponding to a cross-section taken along line VII-VII in FIG. 8.

As illustrated in FIG. 7, wavelength conversion element 200 includes a plurality of light receivers 6a to 6e. Wavelength converting member 4 is disposed above the plurality of light receivers 6a to 6e.

In the cross-section illustrated in FIG. 7, wavelength conversion element 200 includes five light receivers 6a to 6e.

As illustrated in FIG. 8, wavelength conversion element 200 in the present embodiment includes fifteen rows in total of light receivers near the central portion of substrate 5 (five rows in the traverse direction and three rows in the longitudinal direction). Eighteen electrodes are disposed in the peripheral portion of substrate 5 so as to surround the light receivers. At this time, among the eighteen electrodes, three of them are common cathode electrodes for the three rows of light receivers in the longitudinal direction, and the remaining fifteen of them are anode electrodes for the fifteen light receivers, respectively.

The plurality of light receivers 6a to 6e is formed, for example, by injecting a p-type dopant into first semiconductor 22, which is an n-type silicon, for each of the regions where second semiconductors 23a to 23e are formed.

Similarly to Modification 1 of Embodiment 1, wavelength conversion element 200 also includes optical filter 40 disposed between wavelength converting member 4 and substrate 5. Optical filter 40 also has an effect to provide a smooth surface of substrate 5 on which wavelength converting member 4 is disposed. Optical filter 40 is formed of a metal film made of a silver alloy, a multilayer dielectric film, a film composed of a mixture of white nanoparticles and a transparent binder, or a film in combination thereof, for example.

### [Light source device]

The light source device according to the present embodiment will now be described with reference to the drawings.

FIG. 9 is a schematic sectional view illustrating a configuration of light source device 201 according to the present embodiment.

As illustrated in FIG. 9, light source device 201 includes wavelength conversion element 200 and light-emitting device 1. Wavelength conversion element 200 and light-emitting device 1 are held by a holding member not illustrated.

In the present embodiment, light source device 201 further includes light converging optical system 3, external connection means 80, first wiring substrate 71, and second wiring substrate 72.

Light-emitting device 1 includes lead pins 13a and 13b connected to first wiring substrate 71.

First wiring substrate 71 is, for example, a print circuit substrate composed of a plastic base substrate and a wiring formed thereon with copper foil.

In first wiring substrate 71, external connection means 80, such as a connector, is packaged, for example.

In light source device 201 according to the present embodiment, light converging optical system 3 is composed of a combination of convex lens 3a and a concave reflecting surface 3b, and converges emitted light 11 onto wavelength conversion element 200.

Wavelength conversion element 200 includes first terminal 55 and second terminal 56 connected to second wiring substrate 72.

Second wiring substrate 72 is, for example, a flexible print circuit substrate composed of a polyimide base film and a wiring formed thereof with copper foil.

Second wiring substrate 72 is electrically connected to first wiring substrate 71.

### [Operation]

The operation of light source device 201 according to the present embodiment will now be described.

Light source device 201 converges emitted light 11, which is emitted from light-emitting device 1, through light converging optical system 3, and emits emitted light 11 to wavelength converting member 4 of wavelength conversion element 200. Wavelength converting member 4 irradiated with emitted light 11 emits white emitted light 90.

At this time, wavelength converting member 4 also emits light to the side of substrate 5, and the light enters the plurality of light receivers.

The light entering the plurality of light receivers generates electron-hole pairs through photoelectric conversion. The electrons and holes generated in the plurality of light receivers are transported from package 50 through second wiring substrate 72 and external connection means 80 to the outside.

In the present embodiment, the state of wavelength converting member 4 can be determined based on the signals from the plurality of light receivers.

Moreover, through the comparison of the signals from the plurality of light receivers, the information on the position of emitted light 11 entering wavelength converting member 4 can be detected.

For this reason, a positional deviation of emitted light 11 entering wavelength converting member 4 caused by a positional deviation of the concave reflecting surface 3b in light converging optical system 3 can be correctly detected.

### (Embodiment 3)

The light source device according to Embodiment 3 will now be described. Unlike light source device 201 according to Embodiment 2, the light source device according to the present embodiment includes an optical system which varies the light path of the light emitted from light-emitting device 1. Differences between the light source device according to the present embodiment and light source device 201 according to Embodiment 2 will be mainly described below.

### [Light source device]

The configuration of the light source device according to the present embodiment will be initially described with reference to the drawings.

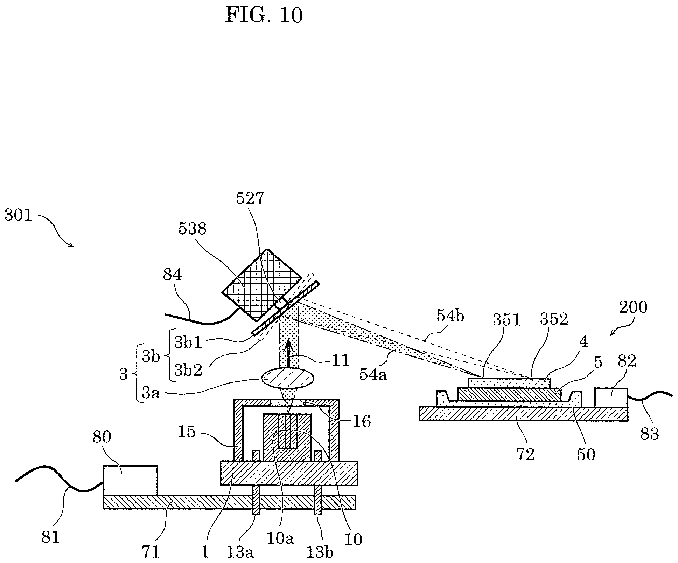

FIG. 10 is a schematic sectional view illustrating a configuration of light source device 301 according to the present embodiment.

In the present embodiment, light converging optical system 3 includes a movable optical element. In other words, light source device 301 according to the present embodiment includes an optical system which varies the light path of emitted light 11 from light-emitting device 1. In such a configuration, emitted light 11 from light-emitting device 1 can be emitted to a desired position of wavelength converting member 4. Moreover, light source device 301 can emit emitted light having a predetermined luminous intensity distribution pattern by scanning emitted light 11 from light-emitting device 1.

Light converging optical system 3 is composed of convex lens 3a and a movable reflecting surface 3b.

Wavelength conversion element 200 includes substrate 5 and wavelength converting member 4 within package 50. Wavelength conversion element 200 is packaged in second wiring substrate 72. Wavelength conversion element 200 is connected through external wiring 83 to an external circuit by external connection means 82.

Reflecting surface 3b is connected through shaft 527 to driver 538.

Driver 538 is connected to external wiring 84. Electricity is fed from the outside to driver 538. This electricity allows the driving of reflecting surface 3b using electrostatic force or magnetic force.

In such a configuration, emitted light 11 can be emitted to a predetermined position of wavelength converting member 4. This configuration also enables the scanning of the irradiation position of emitted light 11.

Specifically, when reflecting surface 3b is located in position 3b1, emitted light 11 is reflected as emitted light 54a, and is emitted to position 351 of wavelength converting member 4.

When reflecting surface 3b is located in position 3b2, emitted light 11 is reflected as emitted light 54b, and is emitted to position 352 of wavelength converting member 4.

Furthermore, in the present embodiment, wavelength conversion element 200 can also detect the position of emitted light 11 in wavelength converting member 4 using a plurality of light receivers.

For example, in the case where the position of emitted light 11 on wavelength converting member 4 lies in position 351, the quantity of light received by the light receiver immediately under position 351 increases, thus increasing the photocurrent output from the light receiver.

In the case where the position of emitted light 11 on wavelength converting member 4 is located in position 352, the quantity of light received by the light receiver immediately under position 352 increases.

### [Circuit configuration]

The circuit configuration of a controller which operates light source device 301 according to the present embodiment will now be described with reference to the drawings.

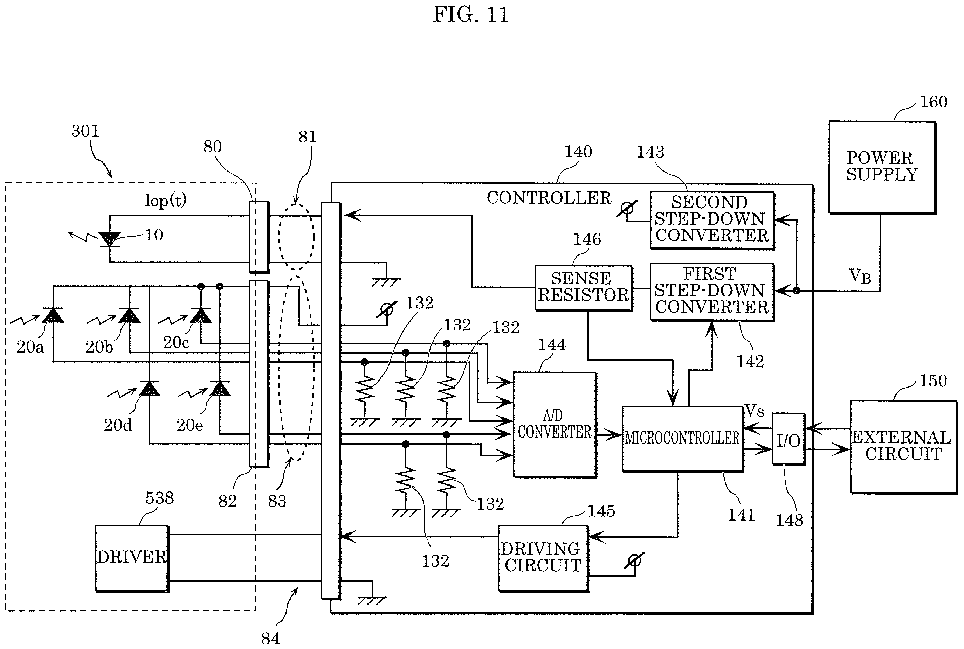

FIG. 11 is a schematic circuit block diagram of light source device 301 according to the present embodiment and controller 140 for driving light source device 301.

As illustrated in FIG. 11, light source device 301 includes semiconductor light-emitting element 10, photodetectors 20a to 20e, external connection means 80 and 82, and driver 538.

Here, each of photodetectors 20a to 20e is a photodiode including light receivers 6a to 6e, first electrode 32, and second electrode 33. In FIG. 11, for simplification, only five photodetectors 20a to 20e are illustrated among all the photodetectors.

External connection means 80 and 82 in light source device 301 are connected to controller 140 through external wiring 81 and 83, respectively. Driver 538 is connected to controller 140 through external wiring 84.

Similarly to Embodiment 1, controller 140 according to the present embodiment includes microcontroller 141, first step-down converter 142, second step-down converter 143, resistor element 132, A/D converter 144, I/O port 148, and sense resistor 146. Controller 140 according to the present embodiment further includes driving circuit 145.

Driving circuit 145 is a circuit for operating driver 538, and operates driver 538 based on the control signals from microcontroller 141.

Because light source device 301 and controller 140 have such a configuration, controller 140 can control the operation of semiconductor light-emitting element 10 and driver 538 in light source device 301.

### [Operation]

The operation of light source device 301 and controller 140 according to the present embodiment will now be described with reference to the drawings.

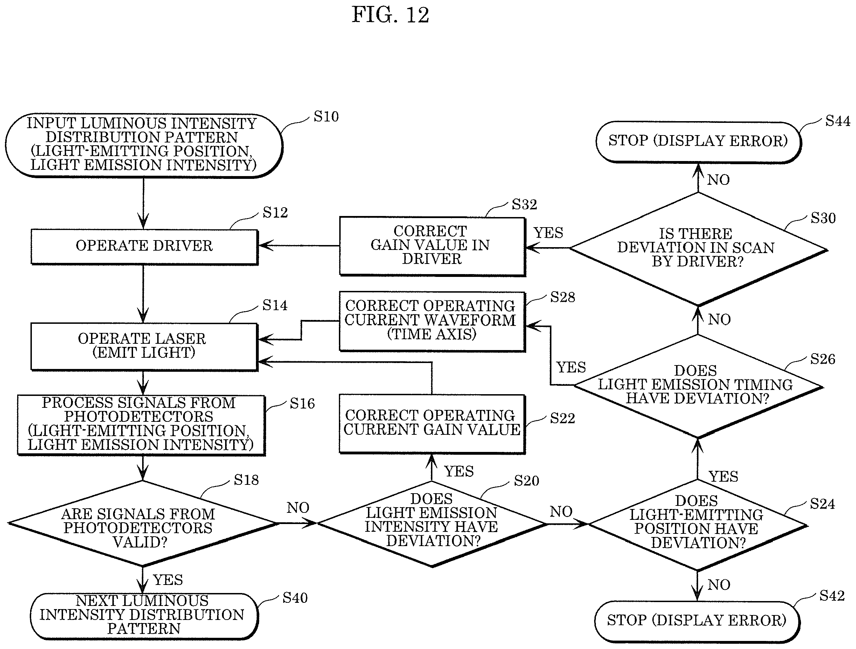

FIG. 12 is a flowchart illustrating an algorithm for control in light source device 301 and controller 140 according to the present embodiment.

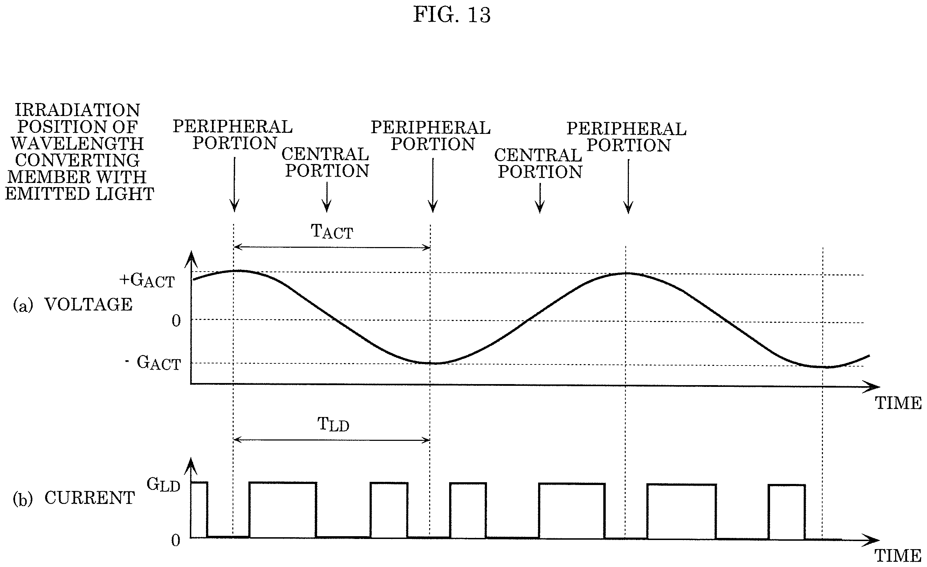

FIG. 13 is a graph illustrating one example of the time dependency of a drive signal input to light source device 301 according to the present embodiment. Graph (a) of FIG. 13 is a graph illustrating the time dependency of the voltage applied from driving circuit 145 to driver 538. Graph (b) of FIG. 13 is a graph illustrating the time dependency of the current fed from first step-down converter 142 to semiconductor light-emitting element 10.

As an example of application of light source device 301 according to the present embodiment, an example will be described in which light source device 301 is used as a headlamp for vehicles such as cars. Initially, the operation of light source device 301 is prepared by starting the engine of a vehicle, for example. By the starting of the engine, power supply 160 feeds electricity to controller 140, and second step-down converter 143 generates power supply voltage Vcc.

External circuit 150 then transmits instruction signals to microcontroller 141, the instruction signals indicating a predetermined pattern of light projection.

Microcontroller 141 performs computations of the instruction signals, and outputs a control signal for controlling driving circuit 145 to driving circuit 145. Thereby, driver 538 which drives reflecting surface 3b is operated.

A cyclic voltage signal having a sine wave illustrated in graph (a) of FIG. 13, for example, is applied to driver 538.

In the example illustrated in graph (a) of FIG. 13, a voltage from -G_{ACT} to +G_{ACT} is applied to driver 538 in a predetermined cycle (2T_{ACT}).

In light source device 301 according to the present embodiment, the irradiation position of wavelength converting member 4 irradiated with emitted light 11 from semiconductor light-emitting element 10 is shifted from a predetermined peripheral portion of wavelength converting member 4 to the central portion, from the central portion to another peripheral portion, from the another peripheral portion to the central portion, and then from the central portion to the predetermined peripheral portion. In the present embodiment, as illustrated in graph (a) of FIG. 13, emitted light 11 is emitted to a peripheral region of wavelength converting member 4 when the voltage applied to driver 538 reaches a maximum value.

Although driver 538 has been described which performs one-dimensional operation (linear operation) in the present embodiment, a driver which performs any other operation can be used. An actuator which performs two-dimensional operation can be used as driver 538. Such an actuator can increase the freedom of the irradiation pattern of wavelength converting member 4 irradiated with light, increasing the freedom of the luminous intensity distribution pattern of the emitted light emitted from wavelength converting member 4.

Microcontroller 141 then operates first step-down converter 142, and a predetermined current Iop(t) flows from first step-down converter 142 through external wiring 81 to semiconductor light-emitting element 10 of light-emitting device 1. In the present embodiment, current Iop(t) is a pulsed current having peak value G_{LD}. Current Iop(t) is modulated at a cycle (2T_{LD}) identical to the cycle (2T_{ACT}) of the voltage applied to driver 538. In other words, current Iop(t) is synchronized with the voltage applied to driver 538.

Light source device 301 and controller 140 having the configuration described above can correctly control the irradiation position of wavelength converting member 4 irradiated with emitted light 11 by receiving a signal from wavelength conversion element 200 based on the algorithm illustrated in FIG. 12, computing the signal, and feeding back the result to driver 538. The algorithm illustrated in FIG. 12 will now be described below.

A luminous intensity distribution pattern is initially input from external circuit 150 to controller 140 (S10). The luminous intensity distribution pattern specifically refers to the information indicating the relation between the position (light-emitting position) of wavelength converting member 4 irradiated with emitted light 11 and the light emission intensity at the position. Here, the light emission intensity is a parameter corresponding to the intensity of emitted light 11, that is, the amount of current fed to semiconductor light-emitting element 10.

In the next step, controller 140 operates driver 538 (S12).

Furthermore, controller 140 feeds a current to semiconductor light-emitting element 10 to operate laser (S14). In other words, controller 140 causes semiconductor light-emitting element 10 to emit light.

Here, controller 140 processes the signals from a plurality of photodetectors in wavelength conversion element 200 to obtain the information indicating the relation between the positions of the photodetectors and the intensities of the signals output from the respective photodetectors (S16).

In the next step, based on the information obtained in Step S16, the validities of the signals from the photodetectors are determined (S18). In other words, it is determined whether the signals obtained from the photodetectors correspond to the luminous intensity distribution pattern input into controller 140 or not. In the case where controller 140 determines that the signals from the photodetectors are valid (YES in S18), the step proceeds to the next step for control based on the luminous intensity distribution pattern (S40). In the case where controller 140 does not determine that the signals from the photodetectors are valid (NO in S18), controller 140 determines whether the light emission intensity has a deviation or not (S20).

Here, in the case where controller 140 determines that the light emission intensity has a deviation (YES in S20), controller 140 corrects the gain value corresponding to the current fed to semiconductor light-emitting element 10 according to the deviation (S22), and returns to Step S14. In the case where controller 140 does not determine that the light emission intensity has a deviation (NO in S20), controller 140 determines whether the light-emitting position has a deviation or not (S24).

Here, in the case where controller 140 does not determine that the light-emitting position has a deviation (NO in S24), controller 140 determines that the correction is impossible, displays an error, and stops the operation (S42).

In the case where controller 140 determines that the light-emitting position has a deviation (YES in S24), controller 140 determines whether the light emission timing has a deviation or not (S26).

Here, in the case where controller 140 determines that the light emission timing has a deviation (YES in S26), controller 140 corrects the waveform of the current fed to semiconductor light-emitting element 10 in the direction of the time axis (S28), and returns to Step S14. In the case where controller 140 does not determine that the light emission timing has a deviation (NO in S26), controller 140 determines whether there is a deviation in the scan by driver 538 or not (S30).

Here, in the case where controller 140 determines that there is a deviation in the scan by driver 538 (YES in S30), controller 140 corrects the gain value corresponding to the voltage applied to driver 538 (S32), and returns to Step S12. In the case where controller 140 does not determine that there is a deviation in the scan by driver 538 (NO in S30), controller 140 determines that the correction is impossible, displays an error, and stops the operation (S44).

As described above, concave reflecting surface 3b is actively driven by driver 538 to vary the irradiation position of wavelength converting member 4 irradiated with emitted light 11. Thereby, the irradiation position of wavelength converting member 4 irradiated with emitted light from light source device 301 can be varied.

Even in this case, because the irradiation position (light-emitting position) of wavelength converting member 4 irradiated with emitted light 11 can be correctly obtained in the photodetectors, the position of the emitted light from light source device 301 can be correctly controlled.

### (Modification 1 of Embodiment 3)

The light source device according to Modification 1 of Embodiment 3 will now be described with reference to the drawings. The light source device according to the present modification has a configuration substantially identical to the configuration of light source device 301 illustrated in FIG. 10.

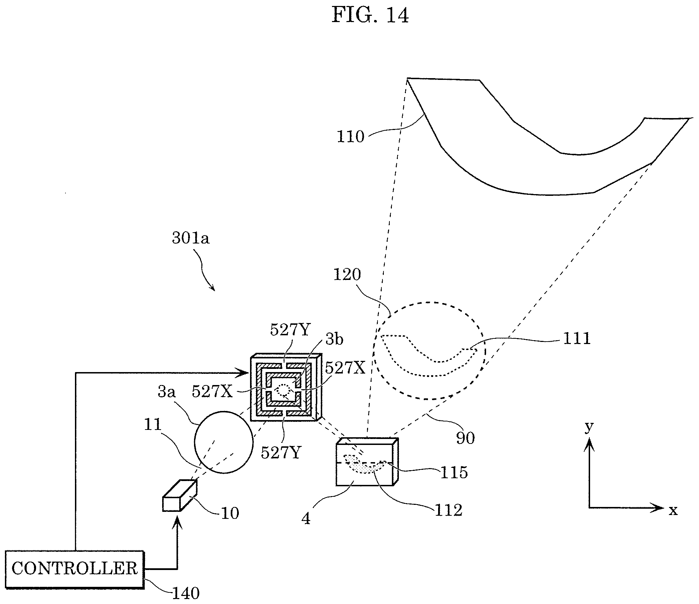

FIG. 14 is a perspective view schematically illustrating part of light source device 301a according to the present modification, in particular, an embodiment of reflecting surface 3b and shaft 527 will be described more in detail.

In the present modification, as illustrated in FIG. 14, light projecting member 120, for example, an aspherical convex lens having a large number of openings is disposed on the light path of the emitted light from wavelength converting member 4 in wavelength conversion element 200.

Such a configuration enables the emission of emitted light having a pattern corresponding to the light emission pattern of wavelength conversion element 200.

In the present embodiment, reflecting surface 3b can be inclined in two directions, i.e., the x-direction and the y-direction (that is, two directions orthogonal to each other). More specifically, reflecting surface 3b and shaft 527 are formed using techniques of micro-electrical-mechanical systems. For example, a micro-movable reflecting surface 3b is suspended and held on a substrate (such as a silicon substrate) with the shaft of the x-direction, i.e., shaft 527X and the shaft of the y-direction, i.e., shaft 527Y. In such a configuration, reflecting surface 3b can be micro-rotated about shaft 527Y to perform scanning with emitted light 11 in the x-direction. Moreover, the micro-rotation of reflecting surface 3b about shaft 527X enables the scanning with emitted light 11 in the y-direction.

Controller 140 feeds the current illustrated in graph (b) of FIG. 13, for example, to semiconductor light-emitting element 10.

Controller 140 feeds the driving voltage illustrated in graph (a) of FIG. 13, for example, to the voltage of driver 538 to be converted into the rotational force of shaft 527Y of reflecting surface 3b.

At this time, emitted light pattern 112 is formed on wavelength converting member 4, and emitted light 90 having a pattern corresponding to pattern 112 is emitted.

The light intensity distribution along center line 115 of wavelength converting member 4 illustrated in FIG. 14 is generated according to the current feeding timing illustrated in graph (b) of FIG. 13.

In the present embodiment, emitted light 90 having luminous intensity distribution pattern 111 enters light projecting member 120. Light projecting member 120 then can emit the light having light projection pattern 110 from light source device 301 to a place away from the light source device.

Moreover, light projection pattern 110 can be adjusted to a desired pattern and brightness through controlling driving circuit 145 and first step-down converter 142 of controller 140 by microcontroller 141.

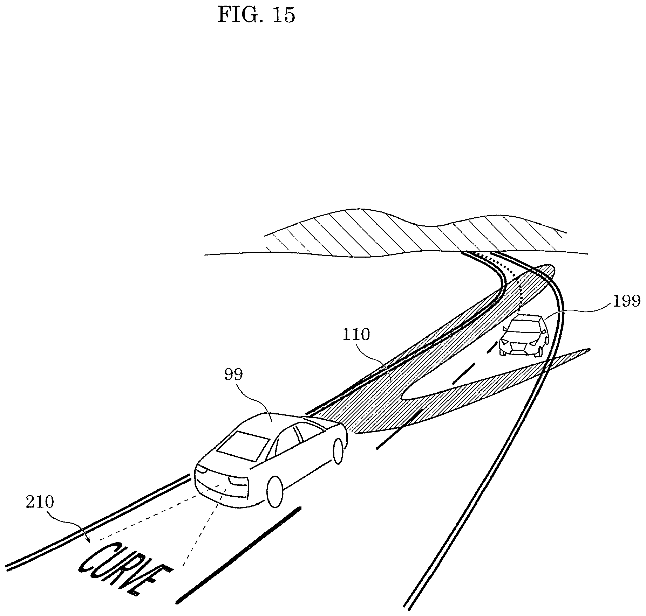

An example of application utilizing this function will be described with reference to FIG. 15.

FIG. 15 is a schematic view illustrating an example of application of light source device 301a according to the present modification.

In FIG. 15, light source device 301 according to the present modification is mounted on vehicle 99 as a high beam headlamp. For safety reasons, the high beam headlamp is preferably used to light a road ahead as far as possible during travel on expressways at night. However, in the case where vehicle 99 lights the high beam to light afar and passes oncoming car 199, the driver on oncoming car 199 is blinded by the light from the high beam headlamp to lose the eyesight of the driver. For this reason, in the case of passing oncoming car 199, generally, the high beam headlamp is turned off, and only the low beam headlamp is turned on.

However, in the case where only the low beam headlamp is turned on, the low beam headlamp covers areas in a short distance. Moreover, the operation to switch between the high beam headlamp and the low beam headlamp according to the absence/presence of the oncoming car puts a burden on the driver.

Accordingly, in this example of application, the positional information of oncoming car 199 can be obtained with a sensor not illustrated, and based on the information, the light of the high beam headlamp having light projection pattern 110 illustrated in FIG. 15 can be emitted so as to avoid oncoming car 199.

As another example of application of light source device 301a according to the present modification, light source device 301a may be disposed in the back of vehicle 99 to emit light having a pattern such as light projection pattern 210 illustrated in FIG. 15. Such a configuration can provide information to a vehicle driving behind vehicle 99. This example of application may be used as a tail lamp of vehicle 99 by using a phosphor having a peak wavelength of 615 nm, for example, as wavelength converting member 4 and suppressing the component at a wavelength of emitted light 11 emitted from light source device 301a.

### (Modification 2 of Embodiment 3)

The wavelength conversion element according to Modification 2 of Embodiment 3 will now be described with reference to the drawings.

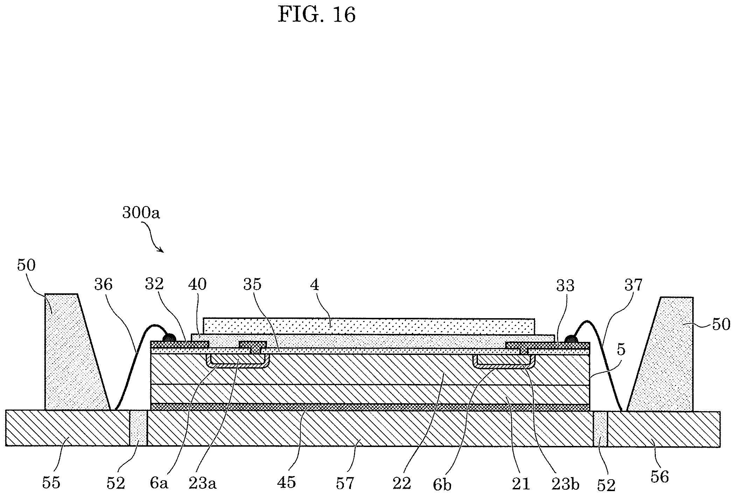

FIG. 16 is a schematic sectional view illustrating a configuration of wavelength conversion element 300a according to the present modification.

As illustrated in FIG. 16, in wavelength conversion element 300a according to the present modification, a plurality of light receivers 6a and 6b is disposed in a periphery of wavelength converting member 4 in a plan view of the surface of substrate 5 on which wavelength converting member 4 is disposed.

As illustrated in graph (a) of FIG. 13, in the case where scan is performed with emitted light 11 using movable reflecting surface 3b, the peripheral portion is irradiated with emitted light 11 at a predetermined cycle.

On the other hand, the amount of inclination of movable reflecting surface 3b can also be adjusted through the adjustment of the maximum value of the voltage applied to the driver which drives reflecting surface 3b.

At this time, light receivers 6a and 6b are disposed on the ends of the regions of wavelength converting member 4 to be scanned.

The scanning position of emitted light 11 is computed using light receivers 6a and 6b disposed in the periphery of wavelength converting member 4. For example, in the case where reflecting surface 3b has an insufficient amount of inclination, the photocurrent is reduced in at least part of light receivers 6a and 6b. As described above, the scanning position of emitted light 11 can be detected by the plurality of light receivers 6a and 6b disposed in the periphery of wavelength converting member 4.

This configuration also can reduce the region of the light receiver compared to the case where the light receiver is disposed across the entire region of substrate 5 facing wavelength converting member 4. In other words, the wavelength conversion element according to the present modification can detect the position of the light from light-emitting device 1 to wavelength converting member 4, and can reduce the region of the light receivers.

### (Modification 3 of Embodiment 3)

The wavelength conversion element according to Modification 3 of Embodiment 3 will now be described with reference to the drawings.

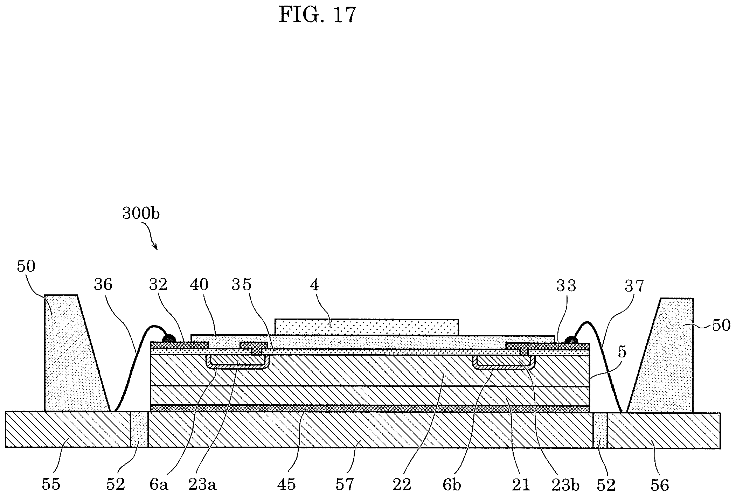

FIG. 17 is a schematic sectional view illustrating a configuration of wavelength conversion element 300b according to the present modification.

As illustrated in FIG. 17, in wavelength conversion element 300b according to the present modification, a plurality of light receivers 6a and 6b is disposed around wavelength converting member 4 in a plan view of the surface of substrate 5 on which wavelength converting member 4 is disposed. In other words, the plurality of light receivers 6a and 6b is disposed in a region outside wavelength converting member 4 and near wavelength converting member 4 in a plan view of the surface of substrate 5.

Wavelength conversion element 300b according to the present modification achieves the same advantageous effects as those of wavelength conversion element 300a according to Modification 2 of Embodiment 3. Furthermore, wavelength conversion element 300b according to the present modification can increase the freedom in design of the configuration of the reflective film in the lower portion of wavelength converting member 4 (that is, between wavelength converting member 4 and substrate 5) by light receivers 6a and 6b disposed around wavelength converting member 4. For example, the light receiver is not present immediately under wavelength converting member 4 in wavelength conversion element 300b according to the present modification. For this reason, optical filter 40 having a selective reflectance of substantially 100% may be disposed in the lower portion of the wavelength converting member.

### (Embodiment 4)

The wavelength conversion element according to Embodiment 4 and a light source device including the wavelength conversion element will now be described. Unlike wavelength conversion element 200 according to Embodiment 3, the wavelength conversion element according to the present embodiment includes a wavelength converting member including a plurality of wavelength conversion regions. Differences between the wavelength conversion element and the light source device according to the present embodiment and those according to Embodiment 3 will be mainly described below with reference to the drawings.

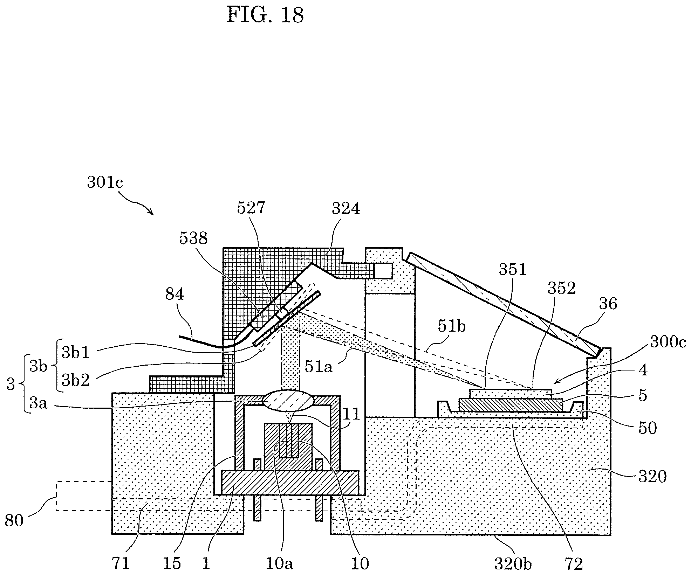

FIG. 18 is a schematic sectional view illustrating a configuration of light source device 301c according to the present embodiment.

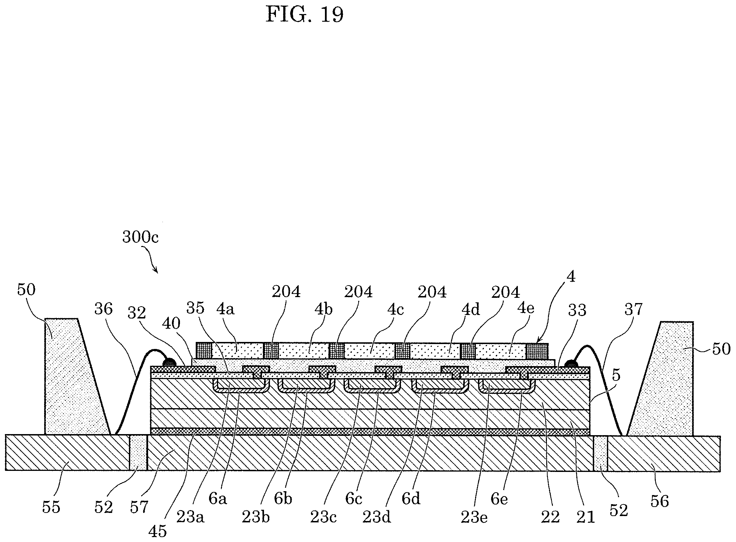

FIG. 19 is a schematic sectional view illustrating a configuration of wavelength conversion element 300c according to the present embodiment.

In light source device 301c according to the present embodiment, the same optical system as that of Embodiment 3 is fixed to support member 320.

Support member 320 has one surface serving as heat dissipating surface 320b, and has the other surface to which light-emitting device 1 and wavelength conversion element 300c are fixed.

Light converging optical system 3 is composed of convex lens 3a and movable reflecting surface 3b.

Convex lens 3a is fixed to a package of light-emitting device 1.

The package of light-emitting device 1 includes semiconductor light-emitting element 10 having optical waveguide 10a. Semiconductor light-emitting element 10 is encapsulated in metal can 15. At this time, convex lens 3a is fixed to the opening of can 15 with low melting point glass.

Reflecting surface 3b is a micro-electrical-mechanical system, for example, and is connected to driver 538 through shaft 527.

Driver 538 is connected to external wiring 84. Electricity is fed to driver 538 from the outside of driver 538. This electricity causes reflecting surface 3b to move by electrostatic force or magnetic force.

Driver 538 is held with holder 324. Driver 538 is positioned with support member 320, and is fixed thereto.

Wavelength conversion element 300c also includes substrate 5 and wavelength converting member 4 in package 50. Wavelength conversion element 300c is packaged in second wiring substrate 72, and is electrically connected to first wiring substrate 71.

As illustrated in FIG. 19, a plurality of light receivers 6a to 6e is disposed in substrate 5 of wavelength conversion element 300c.

Furthermore, wavelength converting member 4 is divided into wavelength conversion regions 4a to 4e, which are disposed corresponding to light receivers 6a to 6e, respectively. Shielding member 204 having low transmittance of light is disposed between adjacent wavelength conversion regions. Shielding member 204 is composed of a silicone resin mixed with titania (TiO₂) particles, for example.

In the configuration above, emitted light 11 can be emitted to a predetermined position of wavelength converting member 4, and the irradiation position thereof can be varied.

Specifically, as illustrated in FIG. 18, when reflecting surface 3b is located in position 3b1, emitted light 11 is reflected by reflecting surface 3b as emitted light 51a, and is emitted to position 351 of wavelength converting member 4.

When reflecting surface 3b is located in position 3b2, emitted light 11 is reflected by reflecting surface 3b as emitted light 51b, and is emitted to position 352 of wavelength converting member 4.

At this time, because wavelength conversion regions 4a to 4e are disposed corresponding to light receivers 6a to 6e, each light receiver barely receives emitted light from the wavelength conversion region disposed in the upper portion of the other light receiver adjacent to the light receiver.

Accordingly, the information of the emitted light emitted to wavelength converting member 4 can be correctly received by the respective wavelength conversion regions.

Moreover, in wavelength conversion element 300c according to the present embodiment, a wavelength converting member having a plurality of light-emitting regions can be readily formed.

### (Embodiment 5)

The wavelength conversion element according to Embodiment 5 will now be described. Unlike wavelength conversion element 100 according to Embodiment 1, the wavelength conversion element according to the present embodiment includes a light receiver disposed outside the substrate. Differences between the following wavelength conversion element according to the present embodiment and wavelength conversion element 100 according to Embodiment 1 will be mainly described with reference to the drawings.

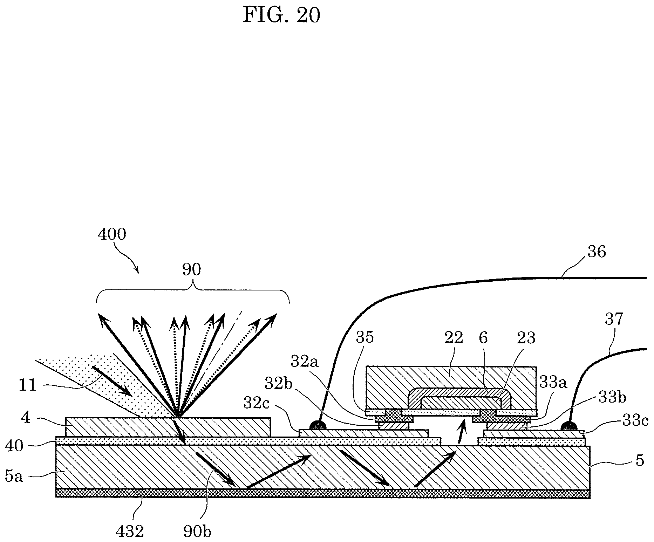

FIG. 20 is a schematic sectional view illustrating a configuration of wavelength conversion element 400 according to the present embodiment.

As illustrated in FIG. 20, wavelength conversion element 400 according to the present embodiment includes substrate 5, wavelength converting member 4 disposed in at least part of a surface of substrate 5 and having a plate or film-shape, and light receiver 6 integrated in substrate 5 and including a p-n junction composed of first semiconductor 22 and second semiconductor 23. In the present embodiment, light receiver 6 is not disposed inside substrate 5 or between substrate 5 and wavelength converting member 4. Substrate 5 includes optical waveguide 5a optically coupled to wavelength converting member 4. Light receiver 6 is disposed on the surface of substrate 5 on which wavelength converting member 4 is disposed. Light receiver 6 is optically coupled to optical waveguide 5a, and is disposed near wavelength converting member 4.

Wavelength conversion element 400 further includes first electrodes 32a to 32c, second electrodes 33a to 33c, protective film 35, optical filter 40, and reflective film 432.

In the present embodiment, substrate 5 does not need to include the first semiconductor and the second semiconductor. It should be noted that substrate 5 includes optical waveguide 5a which propagates light from wavelength converting member 4 to the light receiver or a region near the light receiver without any space interposed. In other words, the light from wavelength converting member 4 enters the inside of substrate 5, and propagates without any space interposed. At this time, substrate 5 preferably conducts and diffuses heat generated in wavelength converting member 4, preventing an increase in temperature of wavelength converting member 4. Accordingly, substrate 5 is preferably composed of a transparent substrate made of sapphire, for example, which has high transmittance to the wavelength of the incident light and also has high thermal conductivity. The transparent substrate is sandwiched between optical filter 40 and reflective film 432 to form optical waveguide 5a. Optical filter 40 reflects part or all of components having the wavelength of the light which is radiated from wavelength converting member 4, enters transparent substrate without any space interposed, and propagates in the transparent substrate.

Optical filter 40 is a film disposed on the surface of substrate 5 on which wavelength converting member 4 is disposed. Accordingly, the light traveling from wavelength converting member 4 toward substrate 5 passes through optical filter 40, and enters the inside of the substrate. Optical filter 40 includes the same material and configuration as those of optical filter 40 according to Modification 1 of Embodiment 1, for example. In other words, optical filter 40 is designed such that the light slightly transmits from wavelength converting member 4 to substrate 5 and the transmitted light which travels from the inside of the substrate toward optical filter 40 is reflected at a high reflectance. To facilitate the propagation of the light from wavelength converting member 4 to light receiver 6 in optical filter 40, a pattern may be formed in addition to the adjustment of the refractive index and the film thickness. To facilitate the propagation of the light, optical filter 40 may have a configuration such that the reflectance increases as the angle of incidence to the surface increases.

Reflective film 432 is a film which reflects the light incident to substrate 5. Reflective film 432 is a film, such as a metal film made of a silver alloy, a multilayer dialectic film, or a film in combination thereof.

First electrode 32c and second electrode 33c are electrodes disposed at positions of substrate 5 on protective film 35 different from the position where wavelength converting member 4 is disposed. First electrode 32c and second electrode 33c are disposed so as not to contact each other. First electrode 32c and second electrode 33c are formed of the same materials as those of first electrode 32 and second electrode 33 according to Embodiment 1.

In the present embodiment, first semiconductor 22, second semiconductor 23, and light receiver 6 are disposed at positions located on the surface of substrate 5 and corresponding to first electrode 32c and second electrode 33c. In other words, first semiconductor 22, second semiconductor 23, and light receiver 6 are disposed at positions on the surface of substrate 5 on which wavelength converting member 4 is disposed, the positions being different from the position of the surface of substrate 5 on which wavelength converting member 4 is disposed. First semiconductor 22, second semiconductor 23, and light receiver 6 are optically coupled to optical waveguide 5a disposed at the position where wavelength converting member 4 is disposed.

Second semiconductor 23 is disposed on the surface of first semiconductor 22 on the side of substrate 5.

Light receiver 6 includes a p-n junction composed of first semiconductor 22 and second semiconductor 23.

Protective film 35 is a protective film disposed on the surfaces of first semiconductor 22 and second semiconductor 23 on the side of substrate 5. Protective film 35 has the same configuration as that of protective film 35 according to Embodiment 1.

First electrode 32a and second electrode 33a are disposed on first semiconductor 22 and second semiconductor 23 on the side of substrate 5, and are electrically connected to first semiconductor 22 and second semiconductor 23, respectively. First electrode 32a and second electrode 33a are composed of a metal such as nickel, aluminum, titanium, platinum, or gold, for example.

First electrode 32b is a conductive member which electrically connects first electrode 32a to first electrode 32c. Second electrode 33b is a conductive member which electrically connects second electrode 33a to second electrode 33c. First electrode 32b and second electrode 33b are composed of solder, for example.

In wavelength conversion element 400 according to the present embodiment having such a configuration, as illustrated in the arrows in FIG. 20, part of the light components emitted from wavelength converting member 4 enters optical waveguide 5a disposed immediately under wavelength converting member 4 of substrate 5, and is reflected by optical filter 40 and reflective film 432. Light receiver 6 then receives at least part of the light components which enter optical waveguide 5a of substrate 5.

At this time, in wavelength conversion element 400 according to the present embodiment, optical waveguide 5a is disposed on substrate 5 on which wavelength converting member 4 is disposed, and light receiver 6 including a p-n junction is integrated. Furthermore, wavelength converting member 4, optical waveguide 5a, and light receiver 6 are optically coupled to each other. In such a configuration, light receiver 6 can detect the light emitted from wavelength converting member 4 substantially near wavelength converting member 4. Accordingly, light receiver 6 can correctly detect a slight change in wavelength converting member 4.

In the present embodiment, light receiver 6 can detect the light emitted from wavelength converting member 4 toward substrate 5 without the light being scattered in the wavelength converting member. Accordingly, light receiver 6 can correctly detect a slight change in wavelength converting member 4.

In the present embodiment, the thickness of wavelength converting member 4 perpendicular to the main surface of substrate 5 is smaller than the maximum width of wavelength converting member 4 parallel to the main surface of substrate 5. For this reason, among the light components generated in wavelength converting member 4, light receiver 6 can detect the light components having a short propagation distance inside wavelength converting member 4. Such light components have an intensity sensitive to a slight change in wavelength converting member 4. Accordingly, light receiver 6 can correctly determine the state of wavelength converting member 4.

Moreover, in the present embodiment, light receiver 6 is disposed on the surface of substrate 5 using optical waveguide 5a disposed in substrate 5. Such a configuration enables a larger freedom in design of arrangement of light receiver 6 in wavelength conversion element 400. For this reason, light receiver 6 can correctly detect a slight change in wavelength converting member 4.

Thereby, similarly to the wavelength conversion elements according to the embodiments described above, wavelength conversion element 400 according to the present embodiment can correctly detect a slight change in wavelength converting member 4.

To increase the amount of light components entering light receiver 6 among the light components entering substrate 5, a member disposed between light receiver 6 and substrate 5 to reflect or absorb light may be removed. For example, in a plan view of the surface of substrate 5 on which light receiver 6 is disposed, a region including no reflective first electrode and second electrode may be disposed within a region in which light receiver 6 is disposed. Alternatively, in a plan view of the surface of substrate 5, a region including no optical filter 40 may be disposed within a region in which light receiver 6 is disposed. Although the configuration in which light receiver 6 wavelength converting member 4 and are disposed on the same surface of substrate 5 has been described in the present embodiment, any other configuration can be used. The same advantageous effects can be achieved by disposing light receiver 6 on the surface of substrate 5 opposite to wavelength converting member 4.

### (Other modifications)

Although the wavelength conversion elements and the light source devices according to the present disclosure have been described based on the embodiments and modifications thereof, the embodiment and modifications described above should not be construed as limitation to the present disclosure. For example, embodiments obtained from a variety of modifications of these embodiments and modifications conceived by persons skilled in the art, and embodiments achieved with any combination of the components and functions of these embodiments and modifications without departing from the gist of the present disclosure are also included in the present disclosure.

For example, light receiver 6 may be disposed between wavelength converting member 4 and substrate 5. For example, light receiver 6 in the form of a film may be disposed between wavelength converting member 4 and substrate 5.

This configuration also can shorten the distance between wavelength converting member 4 and light receiver 6, and therefore light receiver 6 can correctly detect a slight change in wavelength converting member 4.

### INDUSTRIAL APPLICABILITY

The present disclosure is applicable to wavelength conversion elements and light source devices used in the field of displays for projecting display devices or the field of lighting, such as lighting for vehicles, industrial lighting, and medical lighting.

### REFERENCE MARKS IN THE DRAWINGS

1 light-emitting device
3 light converging optical system
3a convex lens
3b reflecting surface
4 wavelength converting member
4a, 4b, 4c, 4d, 4e wavelength conversion regions
4x material degeneration
4y crack
5 substrate
6, 6a, 6b, 6c, 6d, 6e light receiver
10 semiconductor light-emitting element
11, 51a, 51b, 54a, 54b, 90, 90b emitted light
20, 20a, 20b, 20c, 20d, 20e photodetector
21 substrate
22 first semiconductor
23, 23a, 23b, 23c, 23d, 23e second semiconductor
24 third semiconductor
32, 32a, 32b, 32c first electrode
33, 33a, 33b, 33c second electrode
35 protective film
36, 37 metal wire
40 optical filter
55 first terminal
56 second terminal
57 third terminal
71 first wiring substrate
72 second wiring substrate
80, 82 external connection means
81, 83, 84 external wiring
91 first emitted light
92 second emitted light
99 vehicle
100, 100a, 100b, 200, 300a, 300b, 300c, 400 wavelength conversion element
101, 101a, 101b, 201, 301, 301a, 301c light source device
110, 210 light projection pattern
111 luminous intensity distribution pattern
112 emitted light pattern
115 center line
120 light projecting member
132 resistor element
140 controller
142 first step-down converter
143 second step-down converter
144 A/D converter
145 driving circuit
146 sense resistor
148 I/O port
150 external circuit
160 power supply
199 oncoming car
204 shielding member
320 support member
320b heat dissipating surface
324 holder
432 reflective film
527 shaft
538 driver

## Claims

1. A wavelength conversion element, comprising:
a substrate;
a wavelength converting member disposed on at least part of a surface of the substrate and having a shape of a plate or film; and
a light receiver integrated in the substrate and including a p-n junction composed of a p-type semiconductor and an n-type semiconductor.

2. The wavelength conversion element according to claim 1,
wherein the light receiver receives light which enters the substrate.

3. The wavelength conversion element according to claim 1 or 2,
wherein a thickness of the wavelength converting member perpendicular to the surface of the substrate is smaller than a maximum width of the wavelength converting member parallel to the surface of the substrate.

4. The wavelength conversion element according to any one of claims 1 to 3, further comprising:
an optical filter which is disposed between the wavelength converting member and the substrate, and reflects light emitted from the wavelength converting member.

5. The wavelength conversion element according to claim 4,
wherein the optical filter includes one of a metal film and a multilayer dielectric film.

6. The wavelength conversion element according to any one of claims 1 to 5,
wherein the p-type semiconductor and the n-type semiconductor are silicon doped with impurities.

7. The wavelength conversion element according to any one of claims 1 to 6,
wherein the light receiver is disposed inside the substrate or between the substrate and the wavelength converting member.

8. The wavelength conversion element according to any one of claims 1 to 7,
wherein the substrate includes a plurality of light receivers, the plurality of light receivers each being the light receiver.

9. The wavelength conversion element according to any one of claims 1 to 8,
wherein the light receiver is disposed around the wavelength converting member in a plan view of the surface of the substrate.

10. The wavelength conversion element according to any one of claims 1 to 8,
wherein the light receiver is disposed in a periphery of the wavelength converting member in a plan view of the surface of the substrate.

11. The wavelength conversion element according to any one of claims 1 to 10,
wherein the wavelength converting member includes a plurality of wavelength conversion regions.

12. A light source device, comprising:
the wavelength conversion element according to any one of claims 1 to 11; and
a light-emitting device which emits light to be radiated to the wavelength conversion element.

13. The light source device according to claim 12,
wherein the light-emitting device emits laser light.

14. The light source device according to claim 12 or 13, further comprising:
an optical system which varies a light path of the light emitted from the light-emitting device.
